# FASCICULE DE BREVET EUROPEEN

(11) **EP 0 396 446 B1**
(45) Date de publication et mention de la délivrance du brevet: **02.03.1994**
(21) Numéro de dépôt: 90401064.2
(22) Date de dépôt: 19.04.1990
(51) Int. Cl.: G01R 19/00, B64C 13/50, G05D 1/00

(54) **Dispositif pour la surveillance d'un signal électrique variable et composant pour un tel dispositif**
Überwachungsanordnung für ein elektrisches variables Signal und Bauteil dafür
Appliance for monitoring a variable electrical signal and component for this appliance

(30) Priorité: 02.05.1989 FR 8905817
(43) Date de publication de la demande: 07.11.1990
(73) Titulaire: AEROSPATIALE Société Nationale Industrielle, 75781 Paris Cédex 16 (FR)
(72) Inventeur: Colleu, Rachel André Alain, F-31770 Colomiers (FR); Bissey, Bernard Laurent Yves, F-31700 Blagnac (FR); Delibes, Didier René Bernard, F-31300 Toulouse (FR)
(74) Mandataire: Bonnetat, Christian

(56) Documents cités:
- EP-A- 0 007 270
- US-A- 3 882 406
- US-A- 4 105 900
- PATENT ABSTRACTS OF JAPAN, vol. 6, no. 70 (P-113)[948], 6 mai 1982; & JP-A-57 10 804 (TOKYO SHIBAURA DENKI K.K.) 20-01-1982

## Description

La présente invention concerne un dispositif pour la surveillance d'un signal électrique variable, ainsi qu'un composant pour la réalisation dudit dispositif. Quoique non exclusivement, l'invention est particulièrement appropriée à la passivation des pannes des circuits électriques à bord des aéronefs.

On sait que, pour des raisons de sécurité, les ordres de commande d'au moins certains organes d'un aéronef sont élaborés par au moins deux dispositifs différents ; ainsi, en cas de divergence entre les résultats donnés par ces dispositifs, l'aéronef reste commandable par au moins l'un de ces dispositifs pendant le temps de confirmation de cette divergence. Si elle subsiste au-delà de ce temps de confirmation, le système de commande est débrayé. Pour ce faire, les différents dispositifs d'élaboration de signal peuvent être disposés en parallèle, et on peut prévoir un système de sélection du signal comportant un commutateur susceptible de relier la sortie de l'un de ces dispositifs audit organe commande, sous la dépendance de comparateurs respectivement branchés entre les sorties de deux desdits dispositifs. Un tel système de sélection à commutateur et comparateurs présente l'inconvénient d'une certaine inertie, de sorte que, en cas de survenance d'une panne du dispositif relié à l'organe à commander, ledit organe reste quelques instants relié au dispositif en panne avant d'être commandé par un dispositif resté en état de fonctionnement. Il en résulte une discontinuité de commande préjudiciable au pilotage de l'aéronef. De plus, ce système est susceptible de réagir à des phénomènes transitoires, de sorte qu'il peut inutilement déconnecter un dispositif en état de marche pour le remplacer par un autre ; ceci peut présenter des inconvénients lorsque l'on prévoit un dispositif principal d'élaboration de signal et des dispositifs auxiliaires d'élaboration du signal et que l'on désire que l'organe soit de préférence commandé par ledit dispositif principal.

Aussi, pour remédier aux inconvénients des systèmes de sélection de signal à commutateur et comparateurs, on utilise de préférence des systèmes de sélection, appelés voteurs, recevant en permanence et en parallèle les signaux de sortie desdits dispositifs d'élaboration de signal et délivrant à leur sortie celui desdits signaux qui a la valeur médiane par rapport aux autres. Ainsi, on évite toute discontinuité de commande. Cependant, dans le cas où les signaux de sortie des dispositifs d'élaboration de signal ne sont pas rigoureusement en synchronisme, un tel voteur présente l'inconvénient de délivrer un signal de sortie (donc de commande dudit organe commandé) constitué alternativement de tronçons de plusieurs desdits signaux et non pas un signal unique continu choisi parmi les signaux qui lui sont appliqués. De plus, de par leur fonctionnement même, les voteurs ont tendance à favoriser le signal le plus retardé et entraîne donc un retard dans la commande dudit organe. Pour éviter de tels inconvénients, on pourrait utiliser des calculateurs plus rapides, mais cela présenterait d'autres inconvénients, notamment de poids et de coût avec des répercussions sur la fiabilité.

Par ailleurs, par le document US-A-4 105 900, on connaît déjà un appareil de sélection de signal pour des sources de signal redondantes comportant trois dispositifs de limitation. Cet appareil connu nécessite un traitement de signal complexe.

La présente invention a pour objet de remédier aux inconvénients des dispositifs connus rappelés ci-dessus. Elle concerne un dispositif de surveillance qui laisse passer un signal principal tant que celui-ci est estimé valide.

A cette fin, selon l'invention, le dispositif pour la surveillance d'un signal électrique variable à surveiller, du type comportant des premiers, des seconds et des troisièmes moyens de limitation, est remarquable en ce que :
- lesdits premiers moyens de limitation reçoivent ledit signal électrique variable à surveiller, et comportent une sortie qui constitue la sortie dudit dispositif ;
- lesdits seconds moyens de limitation reçoivent en permanence un premier signal électrique limite, représentatif d'une valeur maximale variable pour ledit signal à surveiller, et une première référence, représentative d'une valeur minimale limite pour ledit premier signal électrique limite, le signal à la sortie desdits seconds moyens de limitation étant, soit ledit premier signal électrique limite lorsque celui-ci est supérieur à ladite première référence, soit ladite première référence lorsque ledit premier signal électrique limite est inférieur à cette première référence ;
- lesdits troisièmes moyens de limitation reçoivent en permanence un second signal électrique limite, représentatif d'une valeur minimale variable pour ledit signal à surveiller, et une seconde référence, représentative d'une valeur maximale limite pour ledit second signal électrique limite, le signal de sortie desdits troisièmes moyens de limitation étant, soit ledit second signal électrique limite lorsque celui-ci est inférieur à ladite seconde référence, soit ladite seconde référence lorsque ledit second signal électrique limite est supérieur à cette seconde référence ;
- lesdits premiers moyens de limitation recevant les signaux de sortie desdits seconds et troisièmes moyens de limitation et délivrant à leur sortie :
   . ledit signal à surveiller lorsque celui-ci est compris entre les signaux de sortie desdits seconds et troisièmes moyens de limitation ;
   . le signal de sortie desdits seconds moyens de limitation lorsque ledit signal à surveiller est supérieur à ce dernier signal ; et
   . le signal de sortie desdits troisièmes moyens de limitation lorsque ledit signal à surveiller est inférieur à ce dernier signal.

Ainsi, grâce à la présente invention, ledit signal électrique variable est constamment surveillé par rapport auxdits premier et second signaux électriques limites, qui eux-mêmes sont limités par lesdites première et seconde références. Ce signal électrique variable ne peut donc dépasser des valeurs limites, variables de façon limitée. On voit donc que le dispositif selon l'invention est particulièrement approprié à être mis en oeuvre pour la commande d'organes d'aéronefs.

Dans un mode avantageux de réalisation, lesdits premiers moyens de limitation comportent :
- une première borne pour appliquer le signal de sortie desdits seconds moyens de limitation ;
- une seconde borne pour appliquer le signal de sortie desdits troisièmes moyens de limitation ;
- des premiers moyens de comparaison entre ledit signal variable à surveiller et le signal de sortie desdits seconds moyens de limitation ;
- des seconds moyens de comparaison entre ledit signal variable à surveiller et le signal de sortie desdits troisièmes moyens de limitation ; et
- des moyens de commutation, commandables par lesdits premiers et seconds moyens de comparaison et reliant :
   . l'entrée et la sortie desdits premiers moyens de limitation, lorsque ledit signal électrique variable à surveiller est inférieur au signal de sortie desdits seconds moyens de limitation et supérieur au signal de sortie desdits troisièmes moyens de limitation ;
   . ladite première borne et la sortie desdits premiers moyens de limitation, lorsque ledit signal électrique variable à surveiller est supérieur au signal de sortie desdits seconds moyens de limitation ; et
   . ladite seconde borne et la sortie desdits premiers moyens de limitation, lorsque ledit signal électrique variable à surveiller est inférieur au signal de sortie desdits troisièmes moyens de limitation.

Par ailleurs, lesdits seconds moyens de limitation peuvent comporter :
- une borne pour appliquer ladite première référence ;
- des moyens de comparaison entre ledit premier signal électrique limite et ladite première référence ; et
- des moyens de commutation, commandables par lesdits moyens de comparaison et reliant :
   . l'entrée et la sortie desdits seconds moyens de limitation, lorsque ledit premier signal électrique limite est supérieur à ladite première référence ;
   . ladite borne et la sortie desdits seconds moyens de limitation, lorsque ledit premier signal électrique limite est inférieur à ladite première référence.

De même, lesdits troisièmes moyens de limitation peuvent comporter :
- une borne pour appliquer ladite seconde référence ;
- des moyens de comparaison entre ledit second signal électrique limite et ladite seconde référence ; et
- des moyens de commutation, commandables par lesdits moyens de comparaison et reliant :
   . l'entrée et la sortie desdits troisièmes moyens de limitation, lorsque ledit second signal électrique limite est inférieur à ladite seconde référence ;
   . ladite borne et la sortie desdits troisièmes moyens de limitation, lorsque ledit second signal électrique limite est supérieur à ladite seconde référence.

Ainsi, lesdits premiers, seconds et troisièmes moyens de limitation peuvent présenter la même structure et être constitués par le même composant. En effet, un tel composant permettant la limitation d'un signal électrique variable, du type décrit dans EP-A-0 007 270 et comportant :
- une entrée pour ledit signal électrique variable ;
- une sortie ;
- une première borne pour appliquer une limite supérieure que ledit signal électrique variable ne doit pas dépasser ;
- des moyens de comparaison ; et
- des moyens de commutation commandables ;

est remarquable :
- en ce qu'il comporte une seconde borne pour appliquer une limite inférieure que ledit signal électrique variable ne doit pas dépasser ;
- en ce que lesdits moyens de comparaison comportent des premiers moyens de comparaison entre ledit signal variable et ladite limite supérieure, et des seconds moyens de comparaison entre ledit signal variable et ladite limite inférieure ; et
- en ce que lesdits moyens de commutation, commandables par lesdits premiers et seconds moyens de comparaison, relient :
   . ladite entrée et ladite sortie, lorsque ledit signal électrique variable est inférieur à ladite limite supérieure et supérieur à ladite limite inférieure ;
   . ladite première borne et ladite sortie, lorsque ledit signal électrique est supérieur à ladite limite supérieure ; et
   . ladite seconde borne et ladite sortie, lorsque ledit signal électrique variable est inférieur à ladite limite inférieure.

On voit ainsi que ce composant est adapté parfaitement à remplir les fonctions desdits premiers moyens de limitation, qui utilisent tous les éléments dudit composant. En revanche, lesdits seconds et troisièmes moyens de limitation n'utilisent qu'en partie les possibilités dudit composant.

Dans un mode de réalisation avantageux du dispositif selon l'invention, destiné à la surveillance dudit signal électrique en fonction d'un signal de référence, duquel ledit signal électrique à surveiller ne doit pas s'écarter de plus d'une erreur tolérée, le dispositif comporte de plus un additionneur susceptible d'additionner ladite erreur tolérée audit signal de référence, ainsi qu'un soustracteur susceptible de soustraire ladite erreur tolérée dudit signal de référence et les signaux issus dudit additionneur et dudit soustracteur font respectivement office de premier et de second signal électrique limite. Dans ce cas, le signal à surveiller et le signal de réference peuvent être représentatifs d'une même grandeur obtenue par deux voies différentes.

Il peut être avantageux, du point de vue de la sécurité, de surveiller ledit signal variable, non pas à l'aide d'un seul signal de référence, mais de deux.

Aussi, dans un premier mode de réalisation destiné à la surveillance d'un signal électrique en fonction de deux signaux électriques de référence, desquels ledit signal électrique à surveiller ne doit pas s'écarter de plus d'une erreur tolérée, on prévoit de plus un additionneur et un soustracteur pouvant recevoir, soit l'un desdits signaux électriques de référence, soit l'autre, de façon que lorsque l'un desdits signaux électriques de référence est appliqué audit additionneur, le soustracteur reçoit l'autre desdits signaux électriques de référence, et susceptibles respectivement de former la somme et la différence entre ledit signal électrique de référence reçu et ladite erreur tolérée et les signaux issus dudit additionneur et dudit soustracteur font respectivement office de premier et de second signal électrique limite.

De préférence, un commutateur adresse audit additionneur et audit soustracteur lesdits signaux électriques de référence, en fonction du résultat de la comparaison entre lesdits signaux électriques de référence.

Par ailleurs, un second mode de réalisation destiné à la surveillance d'un signal électrique en fonction de deux signaux électriques de référence, desquels ledit signal électrique à surveiller ne doit pas s'écarter d'erreurs tolérées respectives, est remarquable en ce que, pour chaque signal de référence, il comporte un additionneur et un soustracteur pour former respectivement la somme et la différence entre ledit signal de référence et l'erreur tolérée correspondante, en ce qu'un premier commutateur est disposé à la sortie des deux additionneurs pour former ledit premier signal électrique limite à partir de l'une ou de l'autre desdites sommes et en ce qu'un second commutateur est disposé à la sortie des deux soustracteurs pour former ledit second signal électrique limite à partir de l'une ou l'autre desdites différences.

Avantageusement, ledit premier commutateur est commandé par le résultat de la comparaison entre lesdites sommes, tandis que ledit second commutateur est commandé par le résultat de la comparaison entre lesdites différences. Là encore, ledit signal électrique à surveiller et lesdits signaux électriques de référence peuvent être représentatifs d'une même grandeur.

On remarquera que, dans le contexte d'un bloc de pilotage, le document US-A-3 882 406 décrit la limitation d'un signal électrique variable par rapport à des seuils déterminés.

Les figures du dessin annexé feront bien comprendre comment l'invention peut être réalisée. Sur ces figures, des références identiques désignent des éléments semblables.

La figure 1 est une vue schématique fonctionnelle d'un limiteur conforme à la présente invention.

Les figures 2a, 2b et 2c sont des diagrammes illustrant le fonctionnement du limiteur de la figure 1.

La figure 3 est le schéma synoptique d'un dispositif de surveillance de signal conforme à la présente invention.

Les figures 4a, 4b et 4c sont des diagrammes illustrant le fonctionnement du dispositif de la figure 3.

La figure 5 montre schématiquement une variante de réalisation du dispositif de la figure 3, permettant de surveiller un signal en fonction d'un signal de référence.

Les figures 6a et 6b sont des diagrammes illustrant le fonctionnement du dispositif de la figure 5, en cas de dérive du signal servant à définir le couloir de variations du signal surveillé.

Les figures 7 et 8 donnent le schéma synoptique de deux autres variantes de réalisation permettant de surveiller un signal en fonction de deux signaux de référence.

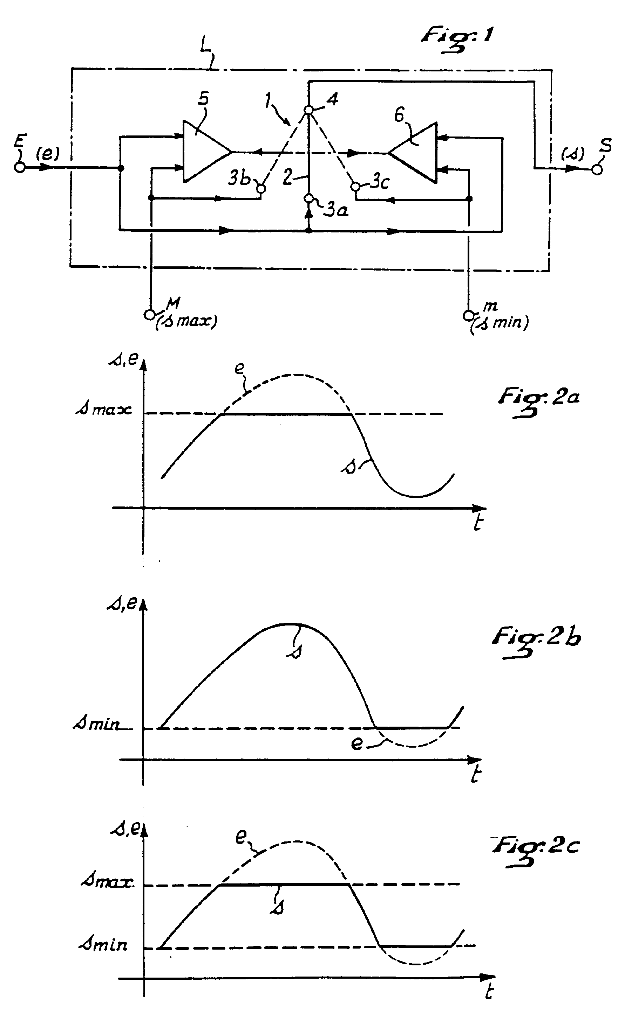

Le limiteur L, représenté schématiquement sur la figure 1, est destiné à constituer un composant de base pour le dispositif de surveillance de signal conforme à la présente invention. Sur cette figure, le limiteur L est représenté schématiquement par les fonctions qu'il réalise afin de bien en faire comprendre la nature et le fonctionnement. Il va de soi que, cependant, un tel limiteur peut être réalisé de toute façon appropriée.

Le limiteur L, tel que représenté sur la figure 1, comporte un commutateur commandé 1, à trois positions. L'organe mobile 2 de ce commutateur est susceptible de relier l'un quelconque de trois plots 3a, 3b, 3c à un plot commun 4. Ce commutateur 1 est commandé par les signaux issus de deux comparateurs, portant respectivement les références 5 et 6. Une entrée de chacun des comparateurs 5 et 6, ainsi que le plot médian 3a sont reliés à une borne d'entrée E du limiteur L. L'autre entrée du comparateur 5 et le plot 3b sont reliés à une autre borne d'entrée M du limiteur L. De même, l'autre entrée du comparateur 6 et le plot 3c sont reliés à une troisième borne d'entrée m du limiteur L. Enfin, la borne de sortie S dudit limiteur est reliée au plot commun 4 du commutateur 1.

Sur la borne d'entrée E, on applique un signal d'entrée variable e, tandis que, sur les bornes M et/ou m, on peut appliquer respectivement des références smax et smin correspondant à des valeurs maximale et minimale que l'on veut voir ne pas être dépassées par le signal de sortie s apparaissant sur la borne de sortie S.

En supposant que la référence smax soit appliquée sur la borne M, on voit que le comparateur S compare en permanence le signal d'entrée e à smax. Tant que le signal d'entrée e est inférieur à smax, l'organe mobile 2 du commutateur 1 reste en position médiane et c'est donc le signal e présent sur le plot 3a qui est transmis à la borne de sortie S. En revanche, dès que le signal d'entrée e devient supérieur à smax, le comparateur 5 fait basculer l'organe mobile 2, de façon que celui-ci relie les plots 3b et 4. C'est donc alors la référence smax qui est appliquée sur la borne de sortie S. Ainsi, le signal de sortie s est constitué par le signal d'entrée e, lorsque celui-ci est inférieur à la référence smax, et par cette référence lorsque le signal e est supérieur à celle-ci. Ceci est illustré par la figure 2a.

On comprendra aisément que, de façon semblable, grâce à la commande du commutateur 1 par le comparateur 6, si la référence smin est appliquée sur la borne m, le signal de sortie s est constitué par le signal d'entrée e, lorsque celui-ci est supérieur à la référence smin, et par cette référence lorsque le signal e est inférieur à cette dernière, comme cela est représenté sur la figure 2b.

Bien entendu, si les références smax et smin sont simultanément appliquées sur les bornes M et m, respectivement, le signal de sortie s est formé par le signal d'entrée e lorsque celui-ci est compris entre smax et smin, et par ces références lorsque ledit signal e les dépasse respectivement (voir la figure 2c).

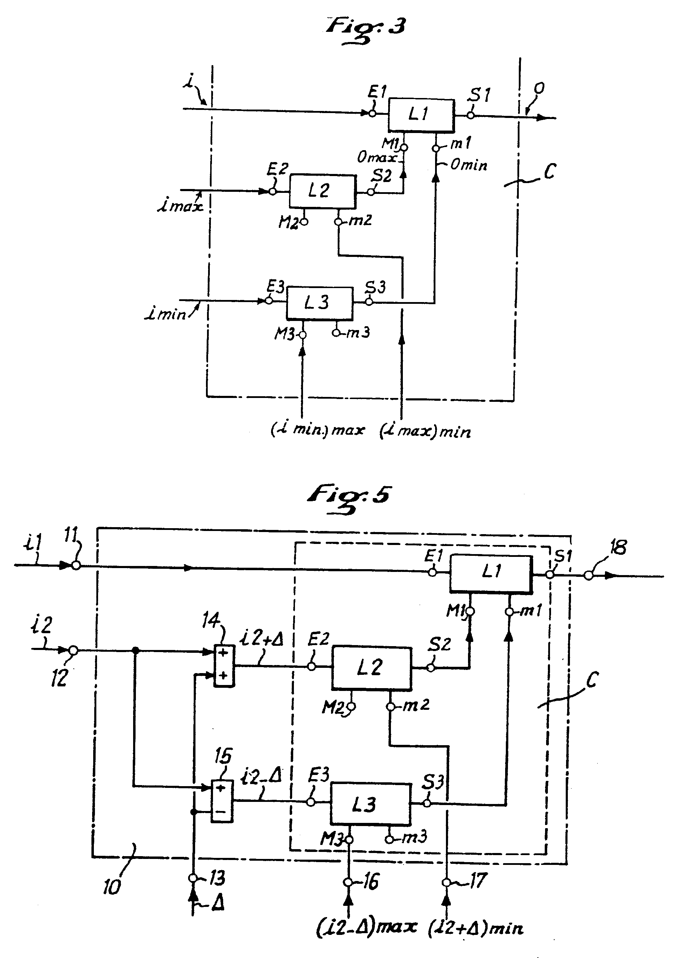

Sur la figure 3, on a représenté un dispositif C de limitation de signal selon l'invention, constitué par la combinaison de trois limiteurs L1, L2 et L3, respectivement identiques au limiteur L de la figure 1. Sur cette figure, les bornes E, S, M et m des différents limiteurs L1, L2 et L3 sont affectées respectivement des indices 1, 2 et 3. La borne d'entrée E1 et la borne de sortie S1 du limiteur L1 forment respectivement la borne d'entrée et celle de sortie du dispositif C et, sur la borne E1 du limiteur L1, est appliqué un signal d'entrée i, par exemple un signal de commande. Sur les bornes d'entrée E2 et E3 des limiteurs L2 et L3, sont respectivement appliqués des signaux d'encadrement variables imax et imin, désirés pour le signal i. Par ailleurs, les bornes de sortie S2 et S3 des limiteurs L2 et L3 sont respectivement reliées aux bornes M1 et m1 du limiteur L1. Enfin, la borne M3 du limiteur L3 et la borne m2 du limiteur L2 sont respectivement reliés à des références (imin)max et (imax)min.

Par application du fonctionnement du limiteur L de la figure 1, explicité par les figures 2a à 2c, on voit que :
- à cause du limiteur L2, le signal omax appliqué à la borne M1 du limiteur L1 est égal à imax, si imax est supérieur à (imax)min, et à (imax)min, si imax est inférieur à (imax)min ;
- à cause du limiteur L3, le signal omin appliqué à la borne m1 du limiteur L1 est égal à imin, si imin est inférieur à (imin)max, et à (imin)max, si imin est supérieur à (imin)max ;
- à cause du limiteur L1, le signal o apparaissant à la sortie de la cellule C, c'est-à-dire sur la borne S1 du limiteur L1, est égal au signal i, si i est compris entre omax et omin et est limité par ces valeurs, en cas de dépassement.

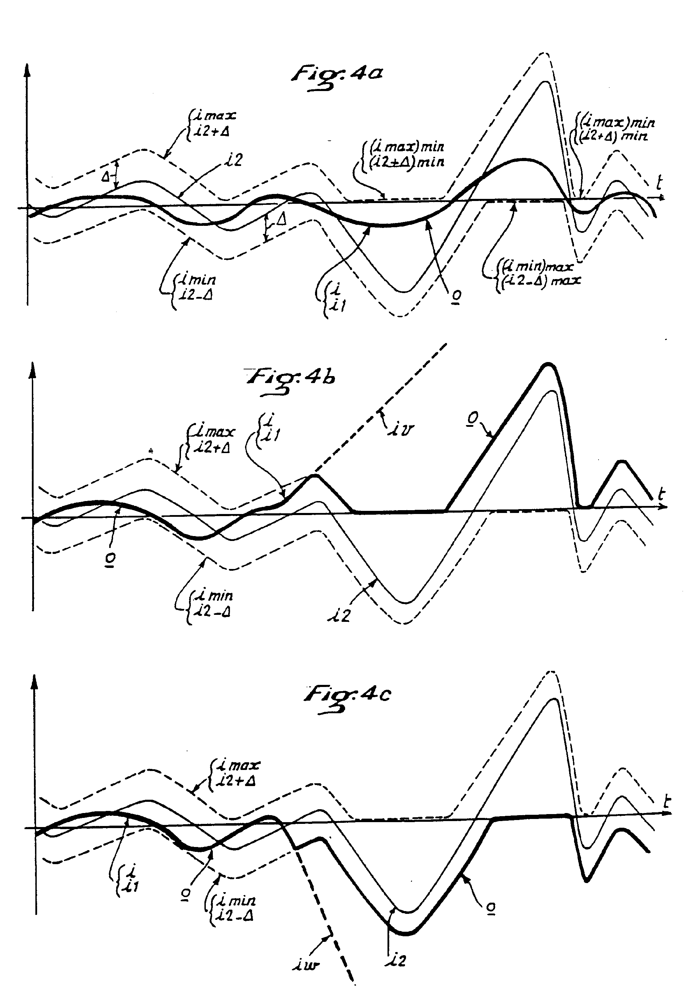

Les figures 4a à 4c illustrent ce fonctionnement du dispositif C de la figure 3. Sur ces figures, on a représenté les amplitudes (en ordonnées) des signaux i, imax et imin en fonction du temps t. De plus, on y a supposé que les références (imax)min et (imin)max étaient toutes deux choisies égales à zéro et que les signaux imax et imin étaient représentatifs de valeurs maximales et minimales acceptables pour i, par exemple de la façon qui sera expliquée à propos du dispositif de la figure 5.

La figure 4a illustre le fonctionnement du dispositif de la figure 3 dans le cas où le signal i ne subit pas de variations anormales. Dans ce cas, le signal i est encadré par les signaux imax et imin et le signal de sortie o est identique au signal i. On remarque toutefois que le signal imax ne peut devenir inférieur à (imax)min = 0 et que le signal imin ne peut devenir supérieur à (imin)max = 0.

Sur la figure 4b, on retrouve les signaux d'encadrement imax et imin et on a supposé que le signal i subissait une forte augmentation indésirée (branche en pointillés iv), qui lui ferait franchir le signal imax. Dans ce cas, le signal de sortie o (en trait continu épais) est formé par le signal i, avant la forte augmentation indésirée, et par le signal imax [pouvant prendre la valeur (imax)min], à partir de celle-ci.

La figure 4c illustre le cas inverse, pour lequel le signal i subit un effondrement prononcé (branche en pointillés iw) qui lui ferait franchir le signal imin. Il en résulte que le signal de sortie o (en trait continu épais) est formé par le signal i avant l'effondrement et par le signal imin [pouvant prendre la valeur (imin)max], à partir dudit effondrement.

Le mode de réalisation 10 du dispositif selon l'invention, montré par la figure 5, met en oeuvre un dispositif C identique à celui représenté sur la figure 3. Ce mode de réalisation 10 est destiné à surveiller un signal i1 appliqué sur sa borne d'entrée 11 (reliée à la borne d'entrée E1 du limiteur L1) par l'intermédiaire d'un signal de référence i2 appliqué sur une autre borne d'entrée 12, les signaux i1 et i2 étant par exemple représentatifs de la même grandeur, mais étant élaborés par des dispositifs différents, de sorte qu'ils sont différents et déphasés l'un par rapport à l'autre. Sur une borne 13 du système 10, est appliquée une référence Δ, représentative de l'erreur tolérée pour le signal i1, par rapport au signal i2.

Le dispositif 10 comporte un additionneur 14 et un soustracteur 15, recevant respectivement les signaux i2 et Δ des bornes 12 et 13. La sortie de l'additionneur 14, sur laquelle apparaît le signal i2+Δ, est reliée à l'entrée E2 du limiteur L2, tandis que la sortie du soustracteur 15, sur laquelle apparaît le signal i2-Δ, est reliée à l'entrée E3 du limiteur L3.

Sur les bornes 16 et 17 du dispositif 10 (reliées respectivement à la borne M3 du limiteur L3 et à la borne m2 du limiteur L2), sont appliquées respectivement des références, correspondant à des valeurs maximale (i2-Δ)max et minimale (i2+Δ)min, désirées respectivement pour le signal i2-Δ et pour le signal i2+Δ.

La sortie 18 du dispositif 10 est reliée à la sortie S1 du limiteur L1.

En comparant les dispositifs des figures 3 et 5, on voit donc que les signaux i2+Δ et i2-Δ jouent respectivement le rôle des signaux imax et imin et que les valeurs limites (i2+Δ)min et (i2-Δ)max correspondent respectivement aux valeurs limites (imax)min et (imin)max.

Dans le cas du dispositif de la figure 5, le couloir de validité du signal i1 (comparable au signal i de la figure 3) est donc déterminé par des signaux obtenus respectivement par addition et soustraction de l'erreur tolérée Δ par rapport au signal i2.

Les diagrammes de fonctionnement des figures 4a, 4b et 4c sont donc valables pour le dispositif de la figure 5. Sur ces diagrammes, on a tracé le signal i2 et représenté l'erreur tolérée Δ.

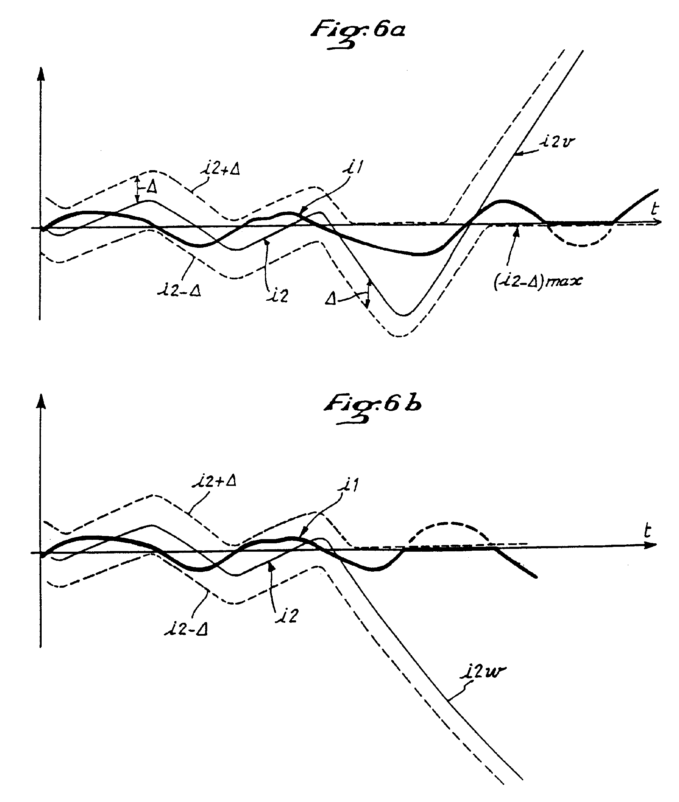

Sur les diagrammes des figures 6a et 6b, on a illustré le fonctionnement du dispositif de la figure 5 dans le cas d'une dérive importante indésirée du signal de référence i2.

En cas d'accroissement important incontrôlé du signal i2 (voir la branche i2v sur la figure 6a), les signaux i2+Δ et i2-Δ croissent également. Le signal i2+Δ n'est pas limité dans sa croissance par le limiteur L2 ; en revanche, l'accroissement du signal i2-Δ est limité à (i2-Δ)max (choisie égale à zéro sur la figure 6a) par le limiteur L3. Par suite, le signal i1 n'est pas limité vers les valeurs supérieures par le limiteur L1, mais, en revanche, est limité à la valeur (i2-Δ)max du côté des valeurs inférieures. Ainsi, le signal o sur la sortie 18 est formé par le signal i1 avant l'accroissement incontrôlé du signal i2, puis, après cet accroissement, soit par les portions dudit signal i1 supérieures à (i2-Δ)max, soit par (i2-Δ)max pour les portions dudit signal i1 inférieures à (i2-Δ)max (en pointillés sur la figure 6a).

En revanche, en cas d'effondrement important incontrôlé du signal i2 (voir la branche i2w sur la figure 6b), les signaux i2+Δ et i2-Δ diminuent également, mais la baisse du signal i2+Δ est limitée à (i2+Δ)min (choisie égale à zéro sur la figure 6b) par le limiteur L2, alors que la chute du signal i2-Δ n'est pas limitée par le limiteur L3. Par suite, le signal o à la sortie 18 est formé par le signal i1 avant l'effondrement du signal i2, puis, après cet effondrement, soit par les portions dudit signal i1 inférieures à (i2+Δ), soit par (i2+Δ)min pour les portions dudit signal i1 supérieures à (i2+Δ) (en pointillés sur la figure 6b).

Pour accroître la sécurité de la surveillance, il peut être intéressant de surveiller le signal i1, non pas à l'aide d'un seul signal i2, mais à l'aide de deux signaux i3 et i4.

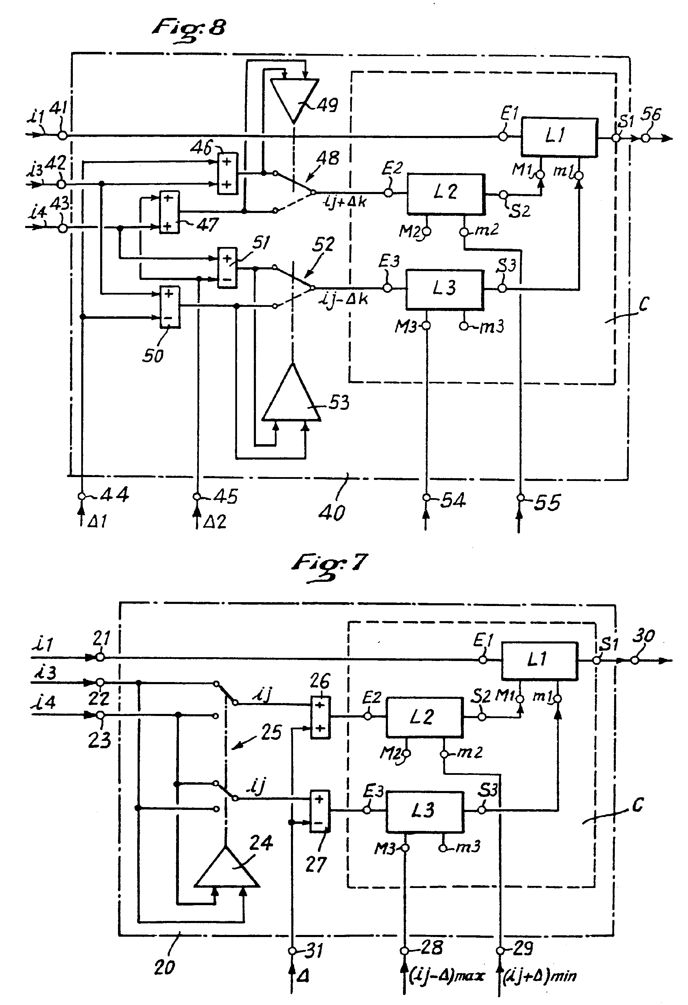

Un mode de réalisation de l'invention correspondant est montré par la figure 7.

Ce mode de réalisation, portant la référence 20, met en oeuvre un dispositif C identique à celui représenté sur les figures 3 et 5. Ce mode de réalisation 20 est destiné à surveiller un signal i1 appliqué sur sa borne d'entrée 21 (reliée à la borne d'entrée E1 du limiteur L1) par l'intermédiaire de deux signaux de référence i3 et i4 respectivement appliqués sur deux autres bornes d'entrée 22 et 23, les signaux i1, i3 et i4 étant par exemple représentatifs de la même grandeur, mais étant élaborés par des dispositifs différents, de sorte qu'ils sont différents et déphasés les uns par rapport aux autres. Sur une borne 31 du système 20, est appliquée une référence Δ, représentative de l'erreur tolérée pour le signal i1, par rapport au signal i3 et par rapport au signal i4.

Le dispositif 20 comporte de plus un comparateur 24, recevant les signaux i3 et i4 et susceptible de commander un commutateur 25, un additionneur 26 et un soustracteur 27. Sous la dépendance du comparateur 24, le commutateur 25 est capable d'adresser simultanément l'un des deux signaux i3 ou i4 à l'additionneur 26, tandis qu'il adresse l'autre de ces signaux (i4 ou i3) au soustracteur 27. Par exemple, le commutateur 25 adresse le signal i3 à l'additionneur 26 et le signal i4 au soustracteur 27 lorsque i3 est supérieur à i4, tandis qu'il adresse le signal i4 à l'additionneur 26 et le signal i3 au soustracteur 27 lorsque i4 est supérieur à i3. Par ailleurs, l'additionneur 26 et le soustracteur 27 reçoivent l'erreur tolérée Δ de la borne 31.

La sortie de l'additionneur 26, sur laquelle apparaît le signal ij+Δ (avec ij=i3 ou ij=i4), est reliée à l'entrée E2 du limiteur L2, tandis que la sortie du soustracteur 27, sur laquelle apparaît le signal ij-Δ, est reliée à l'entrée E3 du limiteur L3.

Sur les bornes 28 et 29 du système 20 (reliées respectivement à la borne M3 du limiteur L3 et à la borne m2 du limiteur L2), sont appliquées respectivement des références (par exemple égales à zéro), correspondant à des valeurs maximale (ij-Δ)max et minimale (ij+Δ)min, désirées respectivement pour le signal ij-Δ et pour le signal ij+Δ.

La sortie 30 du dispositif 20 est reliée à la sortie S1 du limiteur L1.

De ce qui précède, on conçoit aisément que le fonctionnement du dispositif 20 de la figure 7 est identique à celui de la figure 5, à condition de remplacer i2, soit par i3, lorsque i3 est supérieur à i4, soit par i4, lorsque i4 est supérieur à i3.

Dans la variante de réalisation 40 du dispositif selon l'invention, montré par la figure 8, on retrouve également le dispositif C des figures 3, 5 et 7. Le dispositif 40 est destiné, comme le dispositif 20 de la figure 7, à surveiller un signal i1 (appliqué sur sa borne d'entrée 41 reliée à la borne d'entrée E1 du limiteur L1) par l'intermédiaire de deux signaux de référence i3 et i4, respectivement appliqués sur deux autres bornes d'entrée 42 et 43, les signaux i1, i3 et i4 étant par exemple représentatifs de la même grandeur, mais étant élaborés par des voies différentes. Toutefois, dans ce cas, on prend en compte le fait que l'erreur tolérée Δ1 du signal i1 par rapport au signal i3 peut être différente de l'erreur tolérée Δ2 du signal i1 par rapport au signal i4. Le dispositif 40 comporte deux bornes 44 et 45, sur lesquelles sont respectivement appliquées des références représentatives desdites erreurs tolérées Δ1 et Δ2.

Le système 40 comporte de plus :
- un additionneur 46 susceptible de former la somme i3+Δ1 ;
- un additionneur 47 susceptible de former la somme i4+Δ2 ;
- un commutateur 48 susceptible de relier l'une ou l'autre des sorties desdits additionneurs 46 et 47 à l'entrée E2 du limiteur L2 ;
- un comparateur 49 susceptible de commander ledit commutateur 48, en fonction de la comparaison des signaux i3+Δ1 et i4+Δ2 ;
- un soustracteur 50 susceptible de former la différence i3-Δ1 ;
- un soustracteur 51 susceptible de former la différence i4-Δ2 ;
- un commutateur 52 susceptible de relier l'une ou l'autre des sorties desdits soustracteurs 50 et 51 à l'entrée E3 du limiteur L3 ; et
- un comparateur 53 susceptible de commander ledit commutateur 52 en fonction de la comparaison des signaux i3-Δ1 et i4-Δ2.

Le comparateur 49 commande le commutateur 48 de façon que le limiteur L2 reçoive celui des deux signaux i3+Δ1 ou i4+Δ2 qui est le plus grand. Ce signal est désigné ci-après par ij+Δk (avec j = 3 ou 4 et k = 1 ou 2). Par ailleurs, le comparateur 53 commande le commutateur 52, de façon que le limiteur L3 reçoive celui des deux signaux i3-Δ1 et i4-Δ2 qui est le plus petit (désigné ci-après par ij-Δk).

Sur les bornes 54 et 55 (reliées respectivement à la borne M3 du limiteur L3 et à la borne m2 du limiteur L2), sont appliquées respectivement des références, par exemple égales à zéro, correspondant à des valeurs maximale et minimale, désirées respectivement pour le signal ij-Δk et pour le signal ij+Δk.

La sortie 56 du dispositif 40 est reliée à la sortie S1 du limiteur L1.

De ce qui précède, on conçoit aisément que le fonctionnement du dispositif 40 de la figure 8 est identique à celui de la figure 5, à condition de remplacer i2+Δ par ij+Δk et i2-Δ par ij-Δk et à celui de la figure 7, à condition de remplacer Δ1 et Δ2 par Δ.

On peut remarquer que le dispositif 40 est équivalent au dispositif 10, si on applique à ce dispositif 40 des entrées i4 et Δ2 permanentes et égales à zéro.

## Revendications

1. Dispositif (C) pour la surveillance d'un signal électrique variable (i) à surveiller, du type comportant des premiers, des seconds et des troisièmes moyens de limitation,
caractérisé en ce que :
- lesdits premiers moyens de limitation (L1) reçoivent ledit signal électrique variable à surveiller, et comportent une sortie (S1) qui constitue la sortie dudit dispositif (C) ;
- lesdits seconds moyens de limitation (L2) reçoivent en permanence un premier signal électrique limite (imax), représentatif d'une valeur maximale variable pour ledit signal à surveiller, et une première référence (imax)min, représentative d'une valeur minimale limite pour ledit premier signal électrique limite, le signal à la sortie (S2) desdits seconds moyens de limitation étant, soit ledit premier signal électrique limite lorsque celui-ci est supérieur à ladite première référence, soit ladite première référence lorsque ledit premier signal électrique limite est inférieur à cette première référence ;
- lesdits troisièmes moyens de limitation (L3) reçoivent en permanence un second signal électrique limite (imin), représentatif d'une valeur minimale variable pour ledit signal à surveiller, et une seconde référence (imin)max, représentative d'une valeur maximale limite pour ledit second signal électrique limite, le signal de sortie desdits troisièmes moyens de limitation étant, soit ledit second signal électrique limite lorsque celui-ci est inférieur à ladite seconde référence, soit ladite seconde référence lorsque ledit second signal électrique limite est supérieur à cette seconde référence ;
- lesdits premiers moyens de limitation recevant les signaux de sortie desdits seconds et troisièmes moyens de limitation et délivrant à leur sortie :
. ledit signal à surveiller lorsque celui-ci est compris entre les signaux de sortie desdits seconds et troisièmes moyens de limitation ;
. le signal de sortie desdits seconds moyens de limitation lorsque ledit signal à surveiller est supérieur à ce dernier signal ; et
. le signal de sortie desdits troisièmes moyens de limitation lorsque ledit signal à surveiller est inférieur à ce dernier signal.

2. Dispositif selon la revendication 1,
caractérisé en ce que lesdits premiers moyens de limitation (L1) comportent :
- une première borne (M1) pour appliquer le signal de sortie desdits seconds moyens de limitation (L2) ;
- une seconde borne (m1) pour appliquer le signal de sortie desdits troisièmes moyens de limitation (L3) ;
- des premiers moyens de comparaison (5) entre ledit signal variable à surveiller (i) et le signal de sortie desdits seconds moyens de limitation ;
- des seconds moyens de comparaison (6) entre ledit signal variable à surveiller (i) et le signal de sortie desdits troisièmes moyens de limitation ; et
- des moyens de commutation (1), commandables par lesdits premiers et seconds moyens de comparaison et reliant :
. l'entrée (E1) et la sortie (S1) desdits premiers moyens de limitation (L1), lorsque ledit signal électrique variable à surveiller est inférieur au signal de sortie desdits seconds moyens de limitation (L2) et supérieur au signal de sortie desdits troisièmes moyens de limitation (L3) ;
. ladite première borne (M1) et la sortie (S1) desdits premiers moyens de limitation (L1), lorsque ledit signal électrique variable à surveiller est supérieur au signal de sortie desdits seconds moyens de limitation (L2) ; et
. ladite seconde borne (m1) et la sortie (S1) desdits premiers moyens de limitation (L1), lorsque ledit signal électrique variable à surveiller est inférieur au signal de sortie desdits troisièmes moyens de limitation (L3).

3. Dispositif selon la revendication 1,
caractérisé en ce que lesdits seconds moyens de limitation (L2) comportent :
- une borne (m2) pour appliquer ladite première référence (imax)min ;
- des moyens de comparaison (6) entre ledit premier signal électrique limite (imax) et ladite première référence (imax)min ; et
- des moyens de commutation (1), commandables par lesdits moyens de comparaison (6) et reliant :
. l'entrée (E2) et la sortie (S2) desdits seconds moyens de limitation (L2), lorsque ledit premier signal électrique limite (imax) est supérieur à ladite première référence ;
. ladite borne (m2) et la sortie (S2) desdits seconds moyens de limitation (L2), lorsque ledit premier signal électrique limite (imax) est inférieur à ladite première référence.

4. Dispositif selon la revendication 1,
caractérisé en ce que lesdits troisièmes moyens de limitation (L3) comportent :
- une borne (M3) pour appliquer ladite seconde référence (imin)max ;
- des moyens de comparaison (5) entre ledit second signal électrique limite (imin) et ladite seconde référence (imin)max ; et
- des moyens de commutation (1), commandables par lesdits moyens de comparaison (5) et reliant :
. l'entrée (E3) et la sortie (S3) desdits troisièmes moyens de limitation (L3), lorsque ledit second signal électrique limite est inférieur à ladite seconde référence ;
. ladite borne (M3) et la sortie (S3) desdits troisièmes moyens de limitation (L3), lorsque ledit second signal électrique limite est supérieur à ladite seconde référence.

5. Dispositif selon l'une quelconque des revendications 1 à 4, destiné à la surveillance d'un signal électrique (i1) en fonction d'un signal électrique de référence (i2), duquel ledit signal électrique à surveiller ne doit pas s'écarter de plus d'une erreur tolérée (Δ),
caractérisé en ce qu'il comporte de plus un additionneur (14) susceptible d'additionner ladite erreur tolérée audit signal de référence, ainsi qu'un soustracteur (15) susceptible de soustraire ladite erreur tolérée dudit signal de référence et en ce que les signaux issus dudit additionneur et dudit soustracteur font respectivement office de premier et de second signal électrique limite.

6. Dispositif selon la revendication 5,
caractérisé en ce que ledit signal électrique à surveiller et ledit signal électrique de référence sont représentatifs d'une même grandeur obtenue par deux voies différentes.

7. Dispositif selon l'une quelconque des revendications 1 à 4, destiné à la surveillance d'un signal électrique (i1) en fonction de deux signaux électriques de référence (i3 et i4), desquels ledit signal électrique à surveiller ne doit pas s'écarter de plus d'une erreur tolérée (Δ),
caractérisé en ce qu'il comporte de plus un additionneur (26) et un soustracteur (27) pouvant recevoir, soit l'un desdits signaux électriques de référence, soit l'autre, de façon que lorsque l'un desdits signaux électriques de référence est appliqué audit additionneur, le soustracteur reçoit l'autre desdits signaux électriques de référence, et susceptibles respectivement de former la somme et la différence entre ledit signal électrique de référence reçu et ladite erreur tolérée et en ce que les signaux issus dudit additionneur (26) et dudit soustracteur (27) font respectivement office de premier et de second signal électrique limite.

8. Dispositif selon la revendication 7,
caractérisé en ce qu'il comporte un commutateur (25) adressant audit additionneur (26) et audit soustracteur (27) lesdits signaux électriques de référence, en fonction du résultat de la comparaison entre lesdits signaux électriques de référence.

9. Dispositif selon l'une quelconque des revendications 1 à 4, destiné à la surveillance d'un signal électrique (i1) en fonction de deux signaux électriques de référence (i3 et i4), desquels ledit signal électrique à surveiller ne doit pas s'écarter d'erreurs tolérées respectives (Δ1 et Δ2),
caractérisé en ce que, pour chaque signal de référence, il comporte un additionneur (46,47) et un soustracteur (50,51) pour former respectivement la somme et la différence entre ledit signal de référence et l'erreur tolérée correspondante, en ce qu'un premier commutateur (48) est disposé à la sortie des deux additionneurs (46,47) pour former ledit premier signal électrique limite à partir de l'une ou de l'autre desdites sommes et en ce qu'un second commutateur (52) est disposé à la sortie des deux soustracteurs (50,51) pour former ledit second signal électrique limite à partir de l'une ou l'autre desdites différences.

10. Dispositif selon la revendication 9,
caractérisé en ce que ledit premier commutateur (48) est commandé par le résultat de la comparaison entre lesdites sommes, tandis que ledit second commutateur (52) est commandé par le résultat de la comparaison entre lesdites différences.

11. Dispositif selon l'une quelconque des revendications 7 à 10,
caractérisé en ce que ledit signal électrique à surveiller et lesdits signaux électriques de référence sont représentatifs d'une même grandeur, mais sont issus de voies différentes.

12. Composant, permettant la limitation d'un signal électrique variable (e) comportant :
- une entrée (E) pour ledit signal électrique variable (e) ;
- une sortie (S) ;
- une première borne (M) pour appliquer une limite supérieure (smax) que ledit signal électrique variable ne doit pas dépasser ;
- des moyens de comparaison ; et
- des moyens de commutation commandables ;
caractérisé :
- en ce qu'il comporte une seconde borne (m) pour appliquer une limite inférieure (smin) que ledit signal électrique variable ne doit pas dépasser ;
- en ce que lesdits moyens de comparaison comportent des premiers moyens de comparaison (5) entre ledit signal variable (e) et ladite limite supérieure (smax), et des seconds moyens de comparaison (6) entre ledit signal variable (e) et ladite limite inférieure (smin) ; et
- en ce que lesdits moyens de commutation (1), commandables par lesdits premiers et seconds moyens de comparaison, relient :
. ladite entrée (E) et ladite sortie (S), lorsque ledit signal électrique variable est inférieur à ladite limite supérieure (smax) et supérieur à ladite limite inférieure (smin) ;
. ladite première borne (M) et ladite sortie (S), lorsque ledit signal électrique variable est supérieur à ladite limite supérieure (smax) ; et
. ladite seconde borne (m) et ladite sortie (S), lorsque ledit signal électrique variable (e) est inférieur à ladite limite inférieure (smin).

## Patentansprüche

1. Vorrichtung (C) zur Überwachung eines zu überwachenden variablen elektrischen Signals (i), des Typs mit ersten, zweiten und dritten Begrenzungsmitteln,
gekennzeichnet dadurch, daß :
- die ersten Begrenzungsmittel (L1) das zu überwachende variable elektrische Signal empfangen und einen Ausgang (S1) beinhalten, der den Ausgang der Vorrichtung (C) darstellt ;
- die zweiten Begrenzungsmittel (L2) ständing ein erstes elekrisches Grenzsignal (imax) empfangen, das einen variablen Maximalwert für das zu überwachende Signal darstellt und ein erstes Bezugssignal (imax)min, das einen Minimalgrenzwert für das erste elektrische Grenzsignal darstellt, wobei das Signal am Ausgang (S2) der zweiten Begrenzungsmittel entweder das erste elektrische Grenzsignal ist, wenn dieses größer als das erste Bezugssignal ist, oder das erste Bezugssignal, wenn das erste elektrische Grenzsignal kleiner als dieses erste Bezugssignal ist ;
- die dritten Begrenzungsmittel (L3) ständing ein zweites elektrisches Grenzsignal (imin) empfangen, welches einen variablen Minimalwert für das zu überwachende Signal darstellt und einen zweiten Bezugspunkt (imin)max, welcher einen Maximalgrenzwert für das zweite elektrische Grenzsignal darstellt, wobei das Ausgangssignal der dritten Begrenzungsmittel entweder das zweite elektrische Grenzsignal ist, wenn dieses kleiner als der zweite Bezugspunkt ist, oder der zweite Bezugspunkt, wenn das zweite elektrische Grenzsignal größer als dieser zweite Bezugspunkt ist ;
- die ersten Begrenzungsmittel die Ausgangssignale der zweiten und dritten Begrenzungsmittel empfangen und an ihrem Ausgang :
. das zu überwachende Signal, wenn dieses zwischen den Ausgangssignalen der zweiten und dritten Begrenzungsmittel liegt ;
. das Ausgangssignal der zweiten Begrenzungsmittel, wenn das zu überwachende Signal größer als dieses letztere Signal ist ;
. das Ausgangssignal der dritten Begrenzungsmittel, wenn das zu überwachende Signal kleiner als dieses letztere Signal ist ;
anliefern.

2. Vorrichtung gemäß Anspruch 1,
gekennzeichnet dadurch, daß die ersten Begrenzungsmittel (L1) beinhalten:
- eine erste Anschlußklemme (M1) zur Anwendung des Ausgangssignals der zweiten Begrenzungsmittel (L2) ;
- eine zweite Anschlußklemme (m1) zur Anwendung des Ausgangssignals der dritten Begrenzungsmittel (L3) ;
- erste Mittel zum Vergleich (5) des zu überwachenden variablen Signals (i) mit dem Ausgangssignal der zweiten Begrenzungsmittel ;
- zweite Mittel zum Vergleich (6) des zu überwachenden variablen Signals (i) mit dem Ausgangssignal der dritten Begrenzungsmittel ; und
- Umschaltmittel (1), die durch die ersten und zweiten Vergleichsmittel gesteuert werden und die :
. den Eingang (E1) und den Ausgang (S1) der ersten Begrenzungsmittel (L1), wenn das zu überwachende elektrische Signal kleiner als das Ausgangssignal der zweiten Begrenzungsmittel (L2) und größer als das Ausgangssignal der dritten Begrenzungsmittel (L3) ist ;
. die erste Anschlußklemme (M1) und den Ausgang (S1) der ersten Begrenzungsmittel (L1), wenn das zu überwachende elektrische Signal größer ist als das Ausgangssignal der zweiten Begrenzungsmittel (L2) ; und
. die zweite Anschlußklemme (m1) und den Ausgang (S1) der ersten Begrenzungsmittel (L1), wenn das zu überwachende variable elektrische Signal kleiner als das Ausgangssignal der dritten Begrenzungsmittel (L3) ist ;
leitend verbinden.

3. Vorrichtung gemäß Anspruch 1,
gekennzeichnet dadurch, daß die zweiten Begrenzungsmittel (L2) folgendes beinhalten :
- eine Anschlußklemme (m2) zur Anwendung des ersten Bezugspunktes (imax)min ;
- Mittel zum Vergleich (6) des ersten elektrischen Grenzsignals (imax) mit dem ersten Bezugspunkt (imax)min; und
- Umschaltmittel (1), die durch die Vergleichsmittel (6) gesteuert werden und die :
. den Eingang (E2) und den Ausgang (S2) der zweiten Begrenzungsmittel (L2), wenn das erste elektrische Grenzsignal (imax) größer ist als der erste Bezugspunkt ;
. die Anschlußklemme (m2) und den Ausgang (S2) der zweiten Begrenzungsmittel (L2), wenn das erste elektrische Grenzsignal (imax) kleiner als der erste Bezugspunkt ist ;
leitend verbinden.

4. Vorrichtung gemäß Anspruch 1,
gekennzeichnet dadurch, daß die dritten Begrenzungsmittel (L3) folgendes beinhalten:
- eine Anschlußklemme (M3) zur Anwendung des zweiten Bezugspunktes (imin)max ;
- Mittel zum Vergleich (5) des zweiten elektrischen Grenzsignals (imin) mit dem zweiten Bezugspunkt (imin)max : und
- Umschaltmittel (1), welche durch die Vergleichsmittel (5) steuerbar sind und die folgendes leitend verbinden :
. den Eingang (E3) und den Ausgang (S3) der dritten Begrenzungsmittel (L3), wenn das zweite elektrische Grenzsignal kleiner als der zweite Bezugspunkt ist ;
. die Anschlußklemme (M3) und den Ausgang (S3) der dritten Begrenzungsmittel (L3), wenn das zweite elektrische Grenzsignal größer als der zweite Bezugspunkt ist.

5. Vorrichtung gemäß einem der Ansprüche 1 bis 4, vorgesehen zur Überwachung eines elektrischen Signals (i1) in Zusammenhang mit einem elektrischen Bezugssignal (i2), von dem das zu überwachende elektrische Signal um nicht mehr als einen zulässigen Fehler (Δ) abweichen darf,
gekennzeichnet dadurch, daß sie zusätlich eine Additionseinrichtung (14) beinhaltet, welche geeignet ist, den zulässigen Fehler dem Bezugsignal heinzuzufügen, und ein Subtrahierglied (15), welches geeignet ist, den zulässigen Fehler vom Bezugssignal abzuziehen sowie dadurch, daß die Signale, die von der Additionsvorrichtung und von dem Subtrahierglied ausgesandt werden jeweils als erstes und als zweites elektrisches Grenzsignal dienen.

6. Vorrichtung gemäß Anspruch 5,
gekennzeichnet dadurch, daß das zu überwachende elektrische Signal und das elektrische Bezugssignal dieselbe Größe darstellen, die auf zwei unterschiedlichen Wegen ermittelt wurde.

7. Vorrichtung gemäß einem der Ansprüche 1 bis 4, vorgesehen für die Überwachung eines elektrischen Signals (i1) in Zusammenhang mit den beiden elektrischen Bezugssignalen (i3 und i4), von denen das zu überwachende elektrische Signal um nicht mehr als einen zulässigen Fehler (Δ) abweichen darf,
gekennzeichnet dadurch, daß es zusätzlich eine Additionseinrichtung (26) und ein Subtrahierglied (27) beinhaltet, welche eines der beiden elektrischen Bezugssignale empfangen können, so daß, wenn das eine der elektrischen Bezugssignale an der Additionseinrichtung angewendet wird, das Subtrahierglied das andere Bezugssignal empfängt, und welche geeignet sind jeweils die Summe und die Differenz des empfangenen elektrischen Bezugssignals und des zulässigen Fehlers zu bilden, sowie dadurch gekennzeichnet, daß die Signale. die von der Additionseinrichtung (26) und dem Subtrahierglied (27) ausgesandt werden, jeweils als erstes und als zweites elektrisches Grenzsignal dienen.

8. Vorrichtung gemäß Anspruch 7,
gekennzeichnet dadurch, daß sie einen Umschalter (25) beinhaltet, welcher der Additionseinrichtung (26) und dem Subtrahierglied (27) die elektrischen Bezugssignale sendet, und zwar in Zusammenhang mit dem Ergebnis des Vergleichs der elektrischen Bezugssignale.

9. Vorrichtung gemäß einem der Ansprüche 1 bis 4, vorgesehen für die Überwachung eines elektrischen Signals (i1) in Zusammenhang mit zwei Bezugssignalen (i3 und i4), von denen das zu überwachende elektrische Signal nicht um die jeweiligen zulässigen Fehler (Δ1 und Δ2) abweichen darf,
gekennzeichnet dadurch, daß sie fü jedes Bezugssignal eine Additionsvorrichtung (46, 47) und ein Subtrahierglied (50, 51) beinhaltet, um jeweils die Summe und die Differenz des Bezugssignals und des entsprechenden zulässigen Fehlers zu bilden, dadurch, daß ein erster Umschalter (48) am Ausgang der beiden Additionseinrichtungen (46, 47) angebracht ist, um das erste elektrische Grenzsignal ausgehend von der einen oder der anderen der Summen zu bilden und dadurch, daß ein zweiter Umschalter (52) am Ausgang der beiden Subtrahierglieder (50, 51) angebracht ist, um das zweite elektrische Grenzsignal ausgehend von der einen oder der anderen der Differenzen zu bilden.

10. Vorrichtung gemäß Anspruch 9,
gekennzeichnet dadurch. daß der erste Umschalter (48) durch das Ergebnis des Vergleichs der Summen gesteuert wird, während der zweite Umschalter (52) durch das Ergebnis des Vergleichs der Differenzen gesteuert wird.

11. Vorrichtung gemäß einem der Ansprüche 7 bis 10,
gekennzeichnet dadurch, daß das zu überwachende elektrische Signal und die elektrischen Bezugssignale dieselbe Größe darstellen, jedoch auf unterschiedlichem Weg ausgegeben werden.

12. Bauteil, das die Begrenzung eines variablen elektrischen Signals (e) zuläßt und das folgendes beinhaltet :
- einen Eingang (E) für das variable elektrische Signal (e),
- einen Ausgang (S) ;
- eine erste Anschlußklemme (M) zur Anlegung eines oberen Grenzwertes (smax), welchen das variable elektrische Signal nicht überschreiten darf ;
- Vergleichsmittel ; und
- steuerbare Umschaltmittel ;
gekennzeichnet :
- dadurch, daß es eine zweite Anschlußklemme (m) zur Anwendung eines unteren Grenzwertes (smin) beinhaltet, welchen das variable elektrische Signal nicht unterschreiten darf ;
- dadurch, daß die Vergleichsmittel erste Mittel zum Vergleich (5) des variablen Signals (e) mit dem oberen Grenzwert (smax) und zweite Mittel zum Vergleich (6) des variablen elektrischen Signals (e) mit dem unteren Grenzwert (smin) beinhalten ;
- und dadurch, daß die Umschaltmittel (1), welche durch die ersten und zweiten Vergleichsmittel steuerbar sind, folgendes leitend verbinden :
. den Eingang (E) und den Ausgang (S), wenn das variable elektrische Signal kleiner als der obere Grenzwert (smax) und größer als der untere Grenzwert (smin) ist ;
. die erste Anschlußklemme (M) und den Ausgang (S), wenn das variable elektrische Signal größer als der obere Grenzwert (smax) ist ; und
. die zweite Anschlußklemme (m) und den Ausgang (S), wenn das variable elektrische Signal (e) kleiner als der untere Grenzwert (smin) ist.

## Claims

1. Device (C) for monitoring a variable electrical signal (i) to be monitored, of the type including first, second and third limiting means, characterized in that:
- the said first limiting means (L1) receive the said variable electrical signal to be monitored, and include an output (S1) which constitutes the output of the said device (C);
- the said second limiting means (L2) continuously receive a first limit electrical signal (imax), representing a variable maximum value for the said signal to be monitored, and a first reference (imax)min, representing a limit minimum value for the said first limit electrical signal, the signal at the output (S2) of the said second limiting means being either the said first limit electrical signal when the latter is greater than the said first reference, or the said first reference when the said first limit electrical signal is smaller than this first reference;
- the said third limiting means (L3) continuously receive a second limit electrical signal (imin), representing a variable minimum value for the said signal to be monitored, and a second reference (imin)max, representing a limit maximum value for the said second limit electrical signal, the output signal from the said third limiting means being either the said second limit electrical signal when the latter is smaller than the said second reference, or the said second reference when the said second limit electrical signal is greater than this second reference;
- the said first limiting means receiving the output signals from the said second and third limiting means and delivering at their output:
. the said signal to be monitored when the latter lies between the output signals from the said second and third limiting means;
. the output signal from the said second limiting means when the said signal to be monitored is greater than this latter signal; and
. the output signal from the said third limiting means when the said signal to be monitored is smaller than this latter signal. 2.

2. Device according to Claim 1, characterized in that the said first limiting means (L1) include:
- a first terminal (M1) for applying the output signal from the said second limiting means (L2);
- a second terminal (m1) for applying the output signal from the said third limiting means (L3);
- first means of comparison (5) between the said variable signal to be monitored (i) and the output signal from the said second limiting means;
- second means of comparison (6) between the said variable signal to be monitored (i) and the output signal from the said third limiting means; and
- switch-over means (1), controllable by the said first and second comparison means and linking:
. the input (E1) and the output (S1) of the said first limiting means (L1), when the said variable electrical signal to be monitored is smaller than the output signal from the said second limiting means (L2) and greater than the output signal from the said third limiting means (L3);
. the said first terminal (M1) and the output (S1) from the said first limiting means (L1), when the said variable electrical signal to be monitored is greater than the output signal from the said second limiting means (L2); and
. the said second terminal (m1) and the output (S1) from the said first limiting means (L1), when the said variable electrical signal to be monitored is smaller than the output signal from the said third limiting means (L3).

3. Device according to Claim 1, characterized in that the said second limiting means (L2) include:
- a terminal (m2) for applying the said first reference (imax)min;
- means of comparison (6) between the said first limit electrical signal (imax) and the said first reference (imax)min; and
- switch-over means (1), controllable by the said comparison means (6) and linking:
. the input (E2) and the output (S2) from the said second limiting means (L2), when the said first limit electrical signal (imax) is greater than the said first reference;
. the said terminal (m2) and the output (S2) from the said second limiting means (L2) when the said first limit electrical signal (imax) is smaller than the said first reference.

4. Device according to Claim 1, characterized in that the said third limiting means (L3) include:
- a terminal (M3) for applying the said second reference (imin)max;
- means of comparison (5) between the said second limit electrical signal (imin) and the said second reference (imin)max; and
- switch-over means (1), controllable by the said comparison means (5) and linking:
. the input (E3) and the output (S3) from the said third limiting means (L3), when the said second limit electrical signal is smaller than the said second reference;
. the said terminal (M3) and the output (S3) from the said third limiting means (L3), when the said second limit electrical signal is greater than the said second reference.

5. Device according to any one of Claims 1 to 4, intended for monitoring an electrical signal (i1) as a function of a reference electrical signal (i2), from which the said electrical signal to be monitored must not deviate by more than a tolerated error (Δ), characterized in that it further includes an adder (14) capable of adding the said tolerated error to the said reference signal, as well as a subtracter (15) capable of subtracting the said tolerated error from the said reference signal and in that the signals coming from the said adder and from the said subtracter have the function respectively of first and of second limit electrical signals.

6. Device according to Claim 5, characterized in that the said electrical signal to be monitored and the said reference electrical signal are representative of the same quantity obtained by two different paths.

7. Device according to any one of Claims 1 to 4, intended for monitoring an electrical signal (i1) as a function of two reference electrical signals (i3 and i4), from which the said electrical signal to be monitored must not deviate by more than a tolerated error (Δ), characterized in that it further includes an adder (26) and a subtracter (27) which may receive either one of the said reference electrical signals or the other, in such a way that when one of the said reference electrical signals is applied to the said adder, the subtracter receives the other of the said reference electrical signals, and capable respectively of forming the sum and the difference between the said received reference electrical signal and the said tolerated error and in that the signals coming from the said adder (26) and from the said subtracter (27) have the function respectively of first and of second limit electrical signal.

8. Device according to Claim 7, characterized in that it includes a change-over switch (25) addressing the said reference electrical signals to the said adder (26) and to the said subtracter (27) as a function of the result of the comparison between the said reference electrical signals.

9. Device according to any one of Claims 1 to 4, intended for monitoring an electrical signal (i1) as a function of two reference electrical signals (i3 and i4), from which the said electrical signal to be monitored must not deviate by respective tolerated errors (Δ1 and Δ2), characterized in that, for each reference signal, it includes an adder (46, 47) and a subtracter (50, 51) in order respectively to form the sum and the difference between the said reference signal and the corresponding tolerated error, in that a first change-over switch (48) is arranged at the output of the two adders (46, 47) in order to form the said first limit electrical signal from one or the other of the said sums and in that a second change-over switch (52) is arranged at the output of the two subtracters (50, 51) in order to form the said second limit electrical signal from one or the other of the said differences.

10. Device according to Claim 9, characterized in that the said first change-over switch (48) is controlled by the result of the comparison between the said sums, while the said second change-over switch (52) is controlled by the result of the comparison between the said differences.

11. Device according to any one of Claims 7 to 10, characterized in that the said electrical signal to be monitored and the said reference electrical signals are representative of the same quantity, but come from different paths.

12. Component, allowing a variable electrical signal (e) to be limited, including:
- an input (E) for the said variable electrical signal (e);
- an output (S);
- a first terminal (M) for applying an upper limit (smax) which the said variable electrical signal must not exceed;
- comparison means; and
- controllable switch-over means;
characterized:
- in that it includes a second terminal (m) for applying a lower limit (smin) which the said variable electrical signal must not exceed;
- in that the said comparison means include first means of comparison (5) between the said variable signal (e) and the said upper limit (smax), and second means of comparison (6) between the said variable signal (e) and the said lower limit (smin); and
- in that the said switch-over means (1), controllable by the said first and second comparison means, link:
. the said input (E) and the said output (S), when the said variable electrical signal is smaller than the said upper limit (smax) and greater than the said lower limit (smin);
. the said first terminal (M) and the said output (S), when the said variable electrical signal is greater than the said upper limit (smax); and
. the said second terminal (m) and the said output (S), when the said variable electrical signal (e) is smaller than the said lower limit (smin).
